(19)

Europäisches Patentamt
European Patent Office
Office européen des brevets

(11)     **EP 1 959 289 A1**

(12)                      **EUROPEAN PATENT APPLICATION**

(43) Date of publication:
     **20.08.2008 Bulletin 2008/34**

(51) Int Cl.:
     ***G02B 17/08*** (2006.01)

(21) Application number: **07002983.0**

(22) Date of filing: **13.02.2007**

(84) Designated Contracting States:
     **AT BE BG CH CY CZ DE DK EE ES FI FR GB GR
     HU IE IS IT LI LT LU LV MC NL PL PT RO SE SI
     SK TR**
     Designated Extension States:
     **AL BA HR MK RS**

(71) Applicant: **Carl Zeiss SMT AG
     73447 Oberkochen (DE)**

(72) Inventor: **Shafer, David
     Fairfield
     Connecticut 06430 (US)**

(74) Representative: **Muschik, Thomas
     Patentanwälte Ruff, Wilhelm,
     Beier, Dauster & Partner,
     Kronenstrasse 30
     70174 Stuttgart (DE)**

(54)     **Unit magnification projection objective**

(57)     A catadioptric projection objective has a plurality of optical elements arranged along an optical axis to image a pattern arranged in an object surface into an image surface of the projection objective at unit magnification. The optical elements include: concave mirror positioned at a pupil surface; a lens arrangement including a plurality of lenses; a first reflecting surface arranged between the object surface and the lens arrangement to deflect radiation from the object surface towards the concave mirror; and a second reflecting surface arranged between the lens arrangement and the image surface to deflect radiation from the concave mirror towards the image surface. At least one lens of the lens arrangement is positioned in a pupil space optically near to the pupil surface.

Fig. 1

EP 1 959 289 A1

**Description**

BACKGROUND OF THE INVENTION

Field of the Invention

The present invention relates to a catadioptric projection objective, and in particular to large-field unit-magnification catadioptric projection objectives for photolithographic applications.

Description of the Related Art

Photolithography is presently employed not only in sub-micron resolution integrated circuit (IC) manufacturing, but also to an increasing degree in advanced wafer-level IC packaging as well as in semiconductor, microelectromechanical systems (MEMS), nanotechnology (i.e., forming nanoscale structures and devices), and other applications. These applications require multiple imaging capabilities ranging from relatively low resolution (i.e., a few microns) with large depth of focus, to relatively high resolution (i.e. sub-micron) and a high throughput.

A number of modified Wynne-Dyson systems capable of imaging a relatively large field over both a narrow and a broad spectral range in a design wavelength band including one or more of the mercury g-, h- and i-lines at about 436 nm, about 405 nm and about 365 nm, respectively, have been developed in recent years.

US 6,813,098 B2 discloses variable numerical aperture large-field unit-magnification projection systems based on modified Wynne-Dyson systems. The optical systems generally include a main lens group arranged adjacent to, but spaced apart from a concave mirror positioned at a pupil surface of the projection objective. A variable aperture stop at the concave mirror allows to vary the effective image-side numerical aperture NA of the system. US 6,879,383 B2 or US 2006/0092395 A1 disclose other modified Wynne-Dyson systems having similar general design.

US 6,381,077 B1 discloses a unit magnification modified Wynne-Dyson system for use with the mercury i-line. The projection objective includes a concave mirror positioned at the pupil surface, a lens arrangement including a plurality of lenses, a first reflecting surface arranged between the object surface and the lens arrangement to deflect radiation from the object surface towards the concave mirror, and a second reflecting surface arranged between the lens arrangement and the image surface to deflect radiation from the concave mirror towards the image surface. The lens arrangement includes a positive/negative doublet immediately adjacent to the reflecting surfaces. Two additional lenses between the doublet and the concave mirror are arranged close to the doublet to reduce aberrations and telecentricity errors, where the lens closer to the doublet has positive power and the lens further from the doublet has negative power. All lenses of the lens arrangement are optically remote from the pupil surface where the concave mirror is positioned. The projection objective has parallel object and image surface and may be used in a scanning microlithographic apparatus.

US 6,863,403 B2 discloses unit magnification projection objectives for deep ultra-violet (DUV) photolithographic applications. The optical system is a modified Wynne-Dyson system including, along an optical axis, a concave mirror and an aperture stop located at the concave mirror that determines the image-side numerical aperture of the system. The system also includes a lens arrangement with overall positive refracting power arranged adjacent to the concave mirror and spaced apart therefrom. The lens arrangement comprises in order towards the concave mirror: first and second prisms arranged on opposite sides of the optical axis and each having a planar reflecting surface, a first positive lens, a second negative lens, a third positive lens and a fourth negative lens, wherein the lenses of the lens arrangement have surfaces that are non-concentric with respect to the concave mirror surface.

SUMMARY OF THE INVENTION

It is one object of the invention to provide a catadioptric projection objective with unit magnification which has compact dimensions in axial and radial direction and may be used in a scanning projection exposure apparatus.

It is another object of the invention to provide a unit magnification catadioptric projection objective which allows a long-term stable photolithographic manufacturing process with improved stability of optical performance in varying operation conditions.

It is another object of the invention to provide a catadioptric projection objective with unit magnification which can be utilized in a broad design wavelength band including mercurcy g-, h- and I-lines which allows a high throughput of exposed substrates.

It is another object of the invention to provide a catadioptric projection objective with unit magnification having an attractive ratio of cost of manufacturing versus image field area.

It is another object of the invention to provide a catadioptric projection objective with unit magnification having a concave mirror which is easy to manufacture.

To address these and other objects the invention, according to one formulation of the invention, provides a catadioptric projection objective comprising:

a plurality of optical elements arranged along an optical axis to image a pattern arranged in an object surface into an image surface of the projection objective at unit magnification, the optical elements including:

a concave mirror positioned at a pupil surface;
a lens arrangement including a plurality of lenses;
a first reflecting surface arranged between the object surface and the lens arrangement to deflect radiation from the object surface towards the concave mirror;
a second reflecting surface arranged between the lens arrangement and
the image surface to deflect radiation from the concave mirror towards the image surface;

wherein at least one lens of the lens arrangement is positioned in a pupil space adjacent to the pupil surface at a position where the condition $|SAR_P| < 0.2$ is fulfilled for the paraxial sub-aperture ratio $SAR_P$ defined as:

$$SAR_P = (sign\ MRH_P) \cdot (CRH_P / (|MRH_P| + |CRH_P|)),$$

where $CRH_P$ is a paraxial chief ray height and $MRHp$ is a paraxial marginal ray height.

In this definition, the parameter "paraxial sub-aperture ratio" (SARp) is used to define an axial position of an optical surface (e.g. lens surface or mirror surface) within an optical system in terms of optical proximity or optical distance from a field surface or a pupil surface. In this definition, parameter $CRH_P$ is the paraxial chief ray height and $MRHp$ is the paraxial marginal ray height.

Further, in this definition, a lens is positioned in the pupil space if at least one of the lens surfaces, i.e. the lens surface facing the concave mirror, is positioned within the pupil space.

The term "unit magnification" is intended to encompass projection objectives having magnification $|\beta| = 1$, such as in a 1: (-1) system, and magnifications slightly deviating therefrom, for example according to $0.90 < |\beta| < 1.1$. A unit magnification system as used here particularly distinguishes from dedicated reduction projection objectives designed to generate a significantly demagnified image of a pattern on a substrate.

Where the condition $|SAR_P| < 0.2$ is fulfilled for at least one lens of the lens arrangement, that lens is positioned relatively close to the pupil surface where the concave mirror is positioned. As a result, additional degrees of freedom for optical correction are obtained when compared to conventional unit magnification projection objectives based on variants and modifications of Wynne-Dyson systems, where all lenses are positioned significantly farther away from the pupil surface.

Although projection objectives designed according to this aspect of the invention show some similarities to modified Wynne-Dyson systems conventionally used to design unit-magnification projection objectives, placing at least one lens optically close to the pupil surface indicates a novel concept of design significantly deviating from the conventional approach. In some embodiments the lens arrangement includes a pupil-side lens having a pupil-side lens surface immediately adjacent to the concave mirror at a position where the condition $|SAR_P| < 0.2$ holds. In some embodiments, the condition $|SAR_P| < 0.15$ and/or the condition $|SAR_P| < 0.1$ may hold indicating very close proximity to the pupil surface for at least one lens surface of the lens arrangement.

In some embodiments at least two lenses of the lens arrangement are arranged within the pupil space, thereby increasing the degree of freedom of correction for aberrations which may be corrected optically close to a pupil surface. In some embodiments at least three lenses or four or more lenses may be arranged within the pupil space.

In some embodiments lenses of the lens arrangement are optically distributed between field surfaces (formed by the object surface and image surface) and the pupil surface such that at least one lens of the lens arrangement is positioned optically near to a field surface where the condition $|SAR_P| > 0.5$ holds, at least one lens of the lens arrangement is positioned in an intermediate region where the condition $0.5 \geq |SAR_P| \geq 0.2$ holds and at least one lens is arranged within the pupil space. A large number of degrees of freedom for correction are obtained by distributing lenses at positions with significantly differing paraxial sub-aperture ratios.

In "ideal" Wynne-Dyson systems all of the spherical surfaces are nearly concentric, with the centers of curvature located close to where the focal plane would be located in a system without folding of the optical axis. Preferred embodiments of the invention significantly deviate from Wynne-Dyson systems with respect to concentricity of optical surfaces. In some embodiments, the concave mirror is a non-concentric mirror having a concavely curved mirror surface with a center of curvature substantially offset to the position of the object surface in an unfolded system. The concave mirror may be positioned at a distance $D_M$ (measured along the optical axis) from the object surface and may have a radius $R_M$ of curvature, wherein the condition:

$$CON = \left|1 - R_M/D_M\right| > 25\%$$

is fulfilled for the concentricity parameter CON.

For a concentric concave mirror, the condition $R_M/D_M = 1$ holds, such that the concentricity parameter CON becomes zero. On the other hand, where an optical surface deviates significantly from the concentric arrangement, the concentricity parameter CON may become large.

In preferred embodiments the object surface and the image surface are planar surfaces allowing to transfer a pattern from a planar mask onto a planar substrate. Although the object surface and the image surface may include a finite angle, the object surface and the image surface are aligned parallel to each other in preferred embodiments. A parallel arrangement of object surface and image surface facilitates handling of devices manipulating the mask structures bearing the patterns to be imaged, and the substrates to be exposed. A parallel arrangement of object surface and image surface also facilitates incorporation of the projection objective within a scanning-type projection exposure apparatus.

Some embodiments are characterized by very large values for the object-side and image-side working distance, thereby facilitating handling of masks and substrates to be used for exposure. The term "working distance" as used here denotes a distance, measured along the optical axis, between a lens surface directly adjacent to the object surface (or image surface) and the object surface (or image surface, respectively). Only optical elements for folding the optical axis, such as a planar mirror or other planar reflective surface, may be mounted in the working distance. The working distance WD may be larger than a free optical radius (free optical semi diameter) OR1 of a first lens immediately adjacent to the object surface and image surface such that the condition WD > OR1 holds. Preferably, at least one of the conditions WD > 1.1 * OR1 and WD > 1.2 - OR1 and WD > 1.3 - OR1 and WD > 1.4 - OR1 holds. Where the working distance is large, it is possible to arrange the object surface parallel to the image surface, which facilitates a scanning operation. At least of the conditions WD > 100 mm and WD > 110 mm and WD > 120 mm and WD > 130 mm and WD > 140 mm may hold for the working distance WD.

In some embodiments, a first distance D1 measured along the optical axis between the object surface and the first reflecting surface and a second distance D2 measured along the optical axis between the second reflecting surface and the image surface each are larger than the free optical radius (free optical half diameter) $OR_{MAX}$ of a largest lens (lens with the largest diameter) arranged in a region relatively close to the object surface and image surface where the condition $|SAR_P| > 0.4$ holds. Typically, at least one lens of the lens arrangement is positioned in this region. In some embodiments, at least two or at least three lenses are arranged in this region which includes a field space optically close to the object and image surface and which extends some distance beyond that field space. This allows to construct the mounting structure for the lenses and the devices holding the mask and the substrate without interfering with each other. Preferably, the condition $D1 > 1.1 \cdot OR_{MAX}$ and $D2 > 1.1 \cdot OR_{MAX}$ holds. In some embodiments the first and second distances D1, D2, respectively, are larger than the maximum free radius of all lenses outside the pupil space in a region where the condition $|SAR_P| > 0.2$ holds. In some embodiments, the first and second distances D1, D2 respectively are larger than the free optical radius of each of the lenses of the lens arrangement and of the concave mirror, which greatly facilitates arranging object surface and image surface parallel to each other and, at the same time, installing stages for holding the mask and the substrate as desired.

In some embodiments there is no optical element having substantial refractive power arranged between the object surface and the first reflection surface and/or no optical element having substantial refractive power between the second reflecting surface and the image surface. However, since large object-side and image-side working distances may be provided in some embodiments, protective transparent windows essentially designed as plane-parallel plates may be installed between object surface and first reflecting surface and/or between image surface and second reflecting surface where desired. Those protective windows may be used to seal and protect the imaging systems, but may also be used for magnification correction by shaping at least one of the transparent elements in a slightly spherical or aspherical fashion.

In some embodiments the concave mirror is significantly smaller than concave mirrors of conventional modified Wynne-Dyson systems, thereby facilitating manufacturing of the concave mirror and manufacturing of the entire optical system.

In some embodiments, a free optical radius $r_M$ of the concave mirror is smaller than a maximum free optical radius $r_{MAX}$ of the largest lens of the lens arrangement. The difference in free optical radius may be 5% or 10% or more.

The invention further relates to a projection exposure system comprising a light source emitting primary radiation from a wavelength band including mercury g-, h- and i-lines; an illumination system configured to receive light from the light source and to form an illumination field in an exit surface of the illumination system, and a catadioptric projection objective as described above or below.

The previous and other properties can be seen not only in the claims but also in the description and the drawings, wherein individual characteristics may be used either alone or in sub-combinations as an embodiment of the invention and in other areas and may individually represent advantageous and patentable embodiments.

BRIEF DESCRIPTION OF THE DRAWINGS

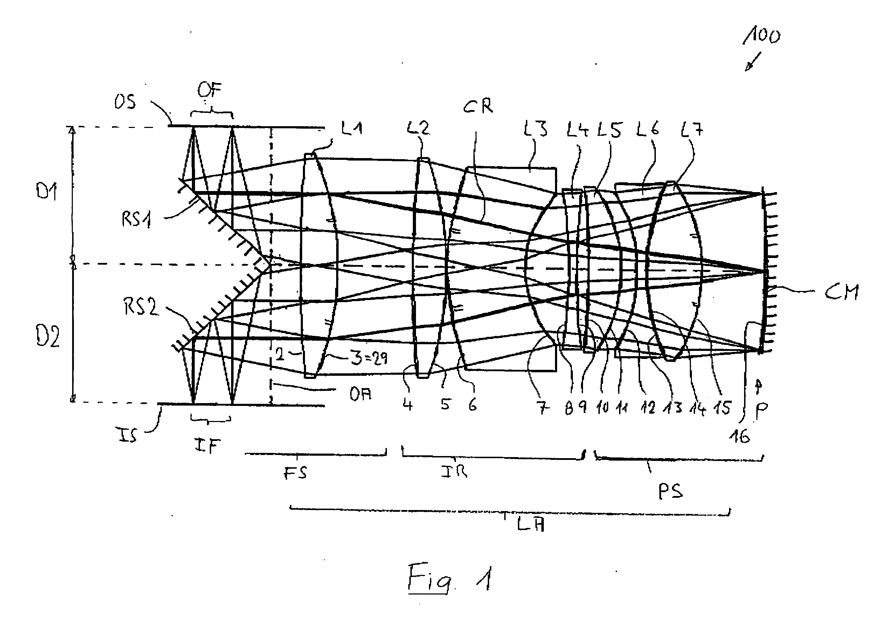

Fig. 1   shows a meridional lens section of an embodiment of a large-field unit-magnification catadioptric projection objective;

DETAILED DESCRIPTION OF THE PREFERRED EMBODIMENTS

In the following description of preferred embodiments of the invention, the term "optical axis" refers to a straight line or a sequence of straight-line segments through the centers of curvature of optical elements. In the exemplary embodiment, the object may be a mask (reticle) bearing a pattern of an integrated circuit or some other pattern, for example a grating pattern or another pattern structure adapted to a particular manufacturing step in advanced wafer-level IC packaging. In the example, the image of the object is projected onto a wafer coated with a layer of a light-sensitive substance serving as a substrate. Other types of substrates, such as components of liquid-crystal displays or substrates for optical gratings, or substrates for nanotechnology are possible.

Fig. 1 shows a first embodiment of a large-field unit-magnification catadioptric projection objective 100 for photolithographic applications.

The projection objective 100 is designed to project an image of a pattern on a reticle arranged in the planar object surface OS (object plane) into a planar image surface IS (image plane) at unit magnification ($|\beta| = 1$) without forming an intermediate image. A rectangular off-axis effective object field OF positioned outside the optical axis OA is thereby projected into an off-axis effective image field IF. A single pupil surface P is formed between object surface OS and image surface IS where a chief ray CR of the imaging (drawn in bold line) intersects the optical axis OA. A concave mirror CM is positioned at the pupil surface.

As used herein, the term "effective image field" means a field in the image surface that the photolithographic system is capable of imaging when it is used in a step-and-repeat mode of operation.

The projection objective includes a single concave mirror CM having a concavely curved mirror surface rotationally symmetric to the optical axis OA. A lens arrangement LA having overall positive refractive power and seven lenses L1 to L7 is arranged adjacent to the concave mirror. A first planar reflecting surface RS1 is arranged between the object surface OS and the lens arrangement LA to deflect radiation from the object surface towards the concave mirror CM. A second planar reflecting surface RS2 is arranged between the lens arrangement LA and the image surface IS to deflect radiation from the concave mirror CM towards the image surface. In the embodiment, the first and second reflecting surfaces RS1, RS2 are formed on a common prism element providing planar outer surfaces oriented at 45° to the optical axis OA to fold the optical axis by 90°. Such folding provides that the object surface OS and the image surface IS are aligned parallel to each other, and perpendicular to the section of the optical axis defined by the concave mirror. The reflecting surface RS1, RS2 may be formed on separate mirror elements, if desired.

There is a relatively large (optical) working distance between the lens surface (surface 2 in table 3) immediately adjacent to the object surface (or image surface) and the object surface (or image surface, respectively). The first and second reflecting surfaces R1, R2 are arranged within that working distance. A first distance D1 measured along the optical axis between the object surface OS and the first reflecting surface RS1, and a second distance D2 measured along the optical axis between the second reflecting surface RS2 and the image surface IS each are larger than the free optical radius (free optical semi diameter) of each of the lenses of the lens arrangement LA and of the concave mirror CM such that all optical elements of the projection objective fit within a space defined by planes including the object surface and image surface, respectively.

The lens arrangement LA consists, in this order from a field-side facing the reflecting surfaces RS1, RS2 to a pupil-side facing the pupil surface P at the concave mirror CM, of a biconvex positive lens L1, a biconvex positive lens L2, a thick negative meniscus lens L3 having a concave side facing the concave mirror CM, a thin biconcave negative lens L4, a positive meniscus lens L5 having a convex lens surface facing the concave mirror, and a negative/positive-doublet formed by a biconcave negative lens L1 and a biconvex positive lens L2 having a very narrow air space formed between facing lens surfaces. All lenses of the lens arrangement LA are passed twice in opposite directions as radiation propagates from the object surface via the concave mirror towards the image surface.

The projection objective 100 is designed for operation with radiation provided by a mercury arc lamp using radiation from a broad design wavelength band including the mercury g-, h- and i-lines between about 360nm and about 440nm at an image-side numerical aperture NA=0.2 in a design image field having design image field radius $R_{DIF}$ = 65 mm. Note that the design image field radius corresponds to the image field height y' (radius of the effective image field) where an outermost field point of the effective image field lies at the outer edge of the design object field. The size of the rectangular effective object field OF and image field IF is 26 mm x 66 mm.

The specification is summarized in Table 1. The leftmost column lists the number of the refractive, reflective, or otherwise designated surface, the second column indicates aspheres (AS), the third column lists the radius of curvature, R, of that surface [mm], the fourth column lists the distance, d [mm], between that surface and the next surface, a parameter that is referred to as the "thickness" of the optical surface, the fifth column lists the material employed for fabricating that optical element, and the sixth column lists the optically utilizable, clear, semi diameter [mm] (or radius r) of the optical component. Reflecting surfaces are indicated in the last column. A radius of curvature R = 0 in a table designates a planar surface (having infinite radius).

The optical surfaces are numbered in Fig. 1. For example, the concave mirror corresponds to surface 16, the largest lens L1 has surfaces 2 and 3, etc. As all lenses are passed twice in opposite directions, each lens surface corresponds to two surface numbers, e.g. surface number 3 corresponds to surface number 29 etc.

**Table 1**

| NA = 0.2 wavelengths: mercury i-, g-, h-Line, field heigth 65 mm | | | | | | |
|---|---|---|---|---|---|---|
| Surface | Radius R [mm] | Asphere | Thickness d [mm] | Material | 1/2 free dia [mm] | |
| 0 | 0 | | 125 | | 65 | |
| 1 | 0 | | -25 | | 106,494 | RS1 |
| 2 | - 1347,629953 | | -31,83212865 | BK7 | 96,818 | |
| 3 | 250,3528341 | AS | -64,95379773 | | 97,891 | |
| 4 | -1210,136493 | | -27,84884952 | BK7 | 95,878 | |
| 5 | 331,5503627 | | -0,999942406 | | 95,451 | |
| 6 | -232.9622655 | AS | -65,96088621 | BK7 | 88,111 | |
| 7 | -99,09864574 | | -37,26467587 | | 67,526 | |
| 8 | 418,8868209 | | -7 | BK7 | 67,786 | |
| 9 | -867,3610633 | | -9,999883235 | | 69,155 | |
| 10 | 647,4632921 | | -27,53196208 | FK51 | 69,788 | |
| 11 | 129,6228375 | | -13,64647829 | | 71,35 | |
| 12 | 135,5791669 | | -7 | SIO2 | 70,036 | |
| 13 | -202,0644868 | | -0,999177128 | | 75,501 | |
| 14 | -203,884093 | | -46,77626369 | CAF2 | 75,978 | |
| 15 | 162,888756 | AS | -54,11800994 | | 77,42 | |
| 16 | 812,8813918 | AS | 54,11800994 | | 70,131 | CM |
| 17 | 162,888756 | AS | 46,77626369 | CAF2 | 77,687 | |
| 18 | -203,884093 | | 0,999177128 | | 76,273 | |
| 19 | -202,0644868 | | 7 | SIO2 | 75,79 | |
| 20 | 135,5791669 | | 13.64647829 | | 70,229 | |
| 21 | 129,6228375 | | 27,53196208 | FK51 | 71,519 | |
| 22 | 647,4632921 | | 9,999883235 | | 69,956 | |
| 23 | -867,3610633 | | 7 | BK7 | 69,321 | |
| 24 | 418,8868209 | | 37,26467587 | | 67,929 | |
| 25 | -99.09864574 | | 65,96088621 | BK7 | 67,667 | |
| 26 | -232,9622655 | AS | 0,999942406 | | 88,273 | |
| 27 | 331,5503627 | | 27,84884952 | BK7 | 95,635 | |
| 28 | -1210,136493 | | 64,95379773 | | 96,055 | |
| 29 | 250,3528341 | AS | 31,83212865 | BK7 | 98,021 | |

(continued)

| NA = 0.2 wavelengths: mercury i-, g-, h-Line, field heigth 65 mm | | | | | | |
|---|---|---|---|---|---|---|
| Surface | Radius R [mm] | Asphere | Thickness d [mm] | Material | 1/2 free dia [mm] | |
| 30 | -1347,629953 | | 25 | | 96,949 | |
| 31 | 0 | | -125 | | 106,545 | RS2 |
| 32 | 0 | | | | 65,002 | |

## Table 1 A

## Aspherical Constants

| Surface Number | 3 | 6 | 15 | 16 |
|---|---|---|---|---|
| K | 0 | 0 | 0 | 0 |
| C1 | -1,58220181E-08 | 1,82383366E-08 | 4,63641043E-08 | -2,44457733E-09 |
| C2 | 1,03637781E-14 | 1,01744013E-12 | 2,24287994E-12 | 1,27280122E-13 |
| C3 | -1,21496025E-17 | 1,78562209E-17 | 2,19741174E-16 | -2,22771982E-17 |
| C4 | 1,67677052E-22 | 1,72720291E-23 | 1,19806698E-20 | 4,34357710E-22 |
| C5 | -1,05512520E-26 | -1,37365022E-25 | -5,57970655E-25 | 1,23991841E-25 |
| C6 | 4,30322103E-31 | 2,48914369E-30 | 1,66427903E-28 | -1,68336613E-29 |

| Surface Number | 17 | 26 | 29 |
|---|---|---|---|
| K | 0 | 0 | 0 |
| C1 | 4,63641043E-08 | 1,82383366E-08 | -1,58220181E-08 |
| C2 | 2,24287994E-12 | 1,01744013E-12 | 1,03637781E-14 |
| C3 | 2,19741174E-16 | 1,78562209E-17 | -1,21496025E-17 |
| C4 | 1,19806698E-20 | 1,72720291E-23 | 1,67677052E-22 |
| C5 | -5,57970655E-25 | -1,37365022E-25 | -1,05512520E-26 |
| C6 | 1,66427903E-28 | 2,48914369E-30 | 4,30322103E-31 |

**Table 1 B**

| Refractive indices | | | |
|---|---|---|---|
| Material | n(365.00nm) | n(435.80nm) | n(404.70nm) |
| BK7 | 1,536269623 | 1,526688062 | 1,530234356 |
| FK51 | 1,500464284 | 1,493646874 | 1,49617935 |
| SiO2 | 1,474550049 | 1,466721898 | 1,469626605 |

(continued)

| Refractive indices | | | |
|---|---|---|---|
| Material | n(365.00nm) | n(435.80nm) | n(404.70nm) |
| CaF2 | 1,444913233 | 1,439488267 | 1,44150534 |

A number of surfaces in Table 1 are aspherical surfaces. Table 1A lists the associated data for those aspherical surfaces, from which the sagitta or rising height p(h) of their surface figures as a function of the height h may be computed employing the following equation:

$$p(h) = [((1/r)h^2)/(1 + SQRT(1 - (1 + K)(1/r)^2 h^2))] + C1 \cdot h^4 + C2 \cdot h^6 + \dots,$$

where the reciprocal value (1/r) of the radius is the curvature of the surface in question at the surface vertex and h is the distance of a point thereon from the optical axis. The sagitta or rising height p(h) thus represents the distance of that point from the vertex of the surface in question, measured along the z-direction, i.e., along the optical axis. The constants K, C1, C2, etc., are listed in Table 1 A.

The optical materials calcium fluoride (CaF$_2$) and fused silica (SiO$_2$) used for the lenses L6 / L7 of the negative/ positive doublet have very low absorption in the design wavelength band. Due to the difference in dispersion between these materials the doublet contributes significantly to color correction. Denotations BK7 and FK51 are names of special optical glasses manufactured by SCHOTT company, Mainz, Germany. Materials with similar refractive index and dispersion values may alternatively be used. Refractive indices are given in Table 1B.

The lens section of Fig. 1 reveals a number of special features of the projection objective. All optical elements providing optical power, i.e. all the lenses of the lens arrangement LA and the concave CM, are arranged in a radially compact arrangement fitting into a cylindrical envelope having a radius defined by the free optical radius OR$_{MAX}$ = 96.8 mm of the lens with the largest diameter, which is biconvex lens L1 immediately adjacent to the reflecting surfaces RS1, RS2. The concave mirror is much smaller than that largest lens, the concave mirror having a free optical radius (OR$_M$ = 70.1 mm) almost 30% smaller than the free optical radius of the largest lens.

The object surface and image surface lie well outside the cylindrical envelope at a radial distance of about 30 mm from the outer edge of lens L1. This is easily recognized by the fact that the first distance D1 = 125 mm and the second distance D2 = 125 mm each are significantly larger than the free semidiameter (free optical radius) of the first lens (which is about 97 mm in this embodiment). A reticle stage carrying a mask having a pattern in the object surface, and a substrate stage carrying a wafer or other substrate in the region of the image surface, may be constructed and arranged without interfering with the mounting structures of the lenses and the concave mirror. Since object surface and image surface are parallel to each other, incorporation in a scanning exposure apparatus is facilitated.

Unlike in typical Wynne-Dyson systems or modifications thereof, the lenses of the lens arrangement LA are distributed in the entire optical space between a field-side (where the object surface and image surface are positioned) and a pupil-side (where the concave mirror CM is positioned). It is considered useful to define the axial position of the lenses or lens surfaces, respectively, by the paraxial sub-aperture ratio SARp which is defined here as:

$$SAR_P = (sign\ MRH_P) \cdot (CRH_P / (|MRH_P| + |CRH_P|)).$$

In this definition, parameter MRHp denotes the paraxial marginal ray height and parameter CRHp denotes the paraxial chief ray height of the imaging process. For the purpose of this application, the term "chief ray" (also known as principle ray) denotes a ray running from an outermost field point (farthest away from the optical axis) of an effectively used object field to the center of the entrance pupil. In rotational symmetric systems the chief ray may be chosen from an equivalent field point in the meridional plane. In projection objectives being essentially telecentric on the object side, the chief ray emanates from the object surface parallel or at a very small angle with respect to the optical axis. The imaging process is further characterized by the trajectory of marginal rays. A "marginal ray" as used herein is a ray running from an axial object field point (field point on the optical axis) to the edge of an aperture stop. That marginal ray may not contribute to image formation due to vignetting when an off-axis effective objective field is used. Both chief ray and marginal ray are used here in the paraxial approximation. The radial distances between such selected rays and the optical axis at a given axial position are denoted as "chief ray height" (CRH) and "marginal ray height" (MRH), respectively.

A definition of the paraxial marginal ray and the paraxial chief ray may be found, for example, in: "Fundamental Optical Design" by Michael J. Kidger, SPIE PRESS, Bellingham, Washington, USA (Chapter 2), which document is incorporated herein by reference.

The paraxial sub-aperture ratio as defined here is a signed quantity providing a measure describing the relative proximity of a position along an optical path to a field plane or a pupil plane, respectively. In the definition given above, the paraxial sub-aperture ratio is normalized to values between -1 and 1, where the condition $|SAR_P| = 1$ holds for a field plane and the condition $SAR_P = 0$ holds for a pupil plane. Therefore, optical surfaces being positioned optically close to a field plane (such as the object surface or the image surface) are characterized by values of the paraxial sub-aperture ratio close to +1 or -1, whereas axial positions optically close to a pupil surface are characterized by values for the paraxial sub-aperture ratio close to zero. The sign of the paraxial sub-aperture ratio indicates the arrangement of the respective position upstream or downstream of a reference surface. For example, the paraxial sub-aperture ratio a small distance upstream of a pupil surface and a small distance downstream of a pupil surface may have the same absolute value, but opposite signs due to the fact that the chief ray height changes its sign upon transiting a pupil surface.

Table 2 lists for each surface of the projection objective the paraxial marginal ray height MRHp, the paraxial chief ray height CRHp and the paraxial sub-aperture ratio SARp resulting therefrom. In Table 2, only the surfaces in the optical path between object plane and concave mirror (surface 16) are listed. Due to the symmetry of the system surface 17 corresponsd to surface 15, surface 18 corresonds to surface 14 etc. (see Table 1)

**Table 2**

| Surface | Radius R [mm] | MRH$_P$ [mm] | CRH$_P$ [mm] | SAR$_P$ |
|---|---|---|---|---|
| 2 | -1347,63 | 30,62 | 44,51 | 0,59 |
| 3 | 250,353 | 34,61 | 44,01 | 0,56 |
| 4 | -1210,136 | 42,33 | 36,39 | 0,46 |
| 5 | 331,55 | 44,15 | 33,96 | 0,43 |
| 6 | -232,962 | 44,18 | 33,78 | 0,43 |
| 7 | -99,099 | 41,12 | 22,38 | 0,35 |
| 8 | 418,887 | 46,68 | 16,98 | 0,27 |
| 9 | -867,361 | 47,63 | 16,42 | 0,26 |
| 10 | 647,463 | 50,00 | 15,29 | 0,23 |
| 11 | 129,623 | 55,08 | 13,42 | 0,20 |
| 12 | 135,579 | 55,96 | 11,34 | 0,17 |
| 13 | -202,064 | 57,19 | 10,79 | 0,16 |
| 14 | -203,884 | 57,58 | 10,71 | 0,16 |
| 15 | 162,889 | 66,24 | 7,08 | 0,10 |
| 16 | 812,881 | 70,97 | 0,00 | 0,00 |

In the optical systems discussed here, all positions where the condition $|SAR_P| < 0.2$ applies are considered to define a pupil space PS which includes axial positions optically close to the pupil surface P, where the concave mirror is positioned. In contrast, values $|SAR_P| > 0.5$ are considered as indicating axial positions relatively close to a field surface, thereby defining a field space FS. Optical surfaces lying within an intermediate region IR defined between the pupil space PS and the field space FS are considered to lie neither particularly close to a field surface nor particularly close to a pupil surface.

Remarkably, four lenses L4 to L7 closest to the concave mirror are all positioned within the pupil space. Biconvex positive L2 and negative meniscus lens L3 are positioned in the intermediate region neither particularly close to a field surface nor particularly close to the pupil surface. In contrast, there is only one lens, namely biconvex positive lens L1, closest to the reflecting surfaces RS1, RS2 positioned in the field space FS optically close to the object surface and image surface, which are optically conjugate field surfaces of the system.

In "ideal" Wynne-Dyson systems the system is basically symmetrical relative to an aperture stop located at the concave mirror, whereby odd order aberrations such as coma, distortion and lateral chromatical aberration are eliminated (The same is true for other symmetrical 1:1 systems). In "ideal" Wynne-Dyson systems all of the spherical surfaces are nearly concentric, with the centers of curvature located close to where the focal plane would be located if the system is not folded.

Unlike many unit magnification projection objectives derived from a basic Wynne-Dyson design, many lens surfaces and the reflecting surface of the concave mirror are non-concentric with respect to the focal plane where the object surface would be in the absence of the folding mirrors. In order to illustrate the level of concentricity or non-concentricity of optical surfaces, Table 3 provides data regarding the radius of curvature, R, of the optical surfaces, the distance $D_{os}$ of each of the optical surfaces to the object surface (measured along the optical axis), the ratio R/D and the concentricity parameter CON = 1 - R/D (in %).

**Table 3**

| Surface | R [mm] | $D_{os}$ [mm] | R/D | 1-R/D [%] |
|---|---|---|---|---|
| 2 | -1347,63 | 150 | -8,9842 | -998,42 |
| 3 | 250,353 | 181,83213 | 1,3768 | 37,6835876 |
| 4 | -1210,136 | 246,78593 | -4,9036 | -590,3585873 |
| 5 | 331,55 | 274,63478 | 1,2072 | 20,72396657 |
| 6 | -232,962 | 275,63472 | -0,8452 | -184,51838 |
| 7 | -99,099 | 341,5956 | -0,2901 | -129,0106196 |
| 8 | 418,887 | 378,86028 | 1,1057 | 10,56503469 |
| 9 | -867,361 | 385,86028 | -2,2479 | -324,7862879 |
| 10 | 647,463 | 395,86016 | 1,6356 | 63,55851521 |
| 11 | 129,623 | 423,39213 | 0,3062 | -69,38464586 |
| 12 | 135,579 | 437,0386 | 0,3102 | -68,97779738 |
| 13 | -202,064 | 444,0386 | -0,4551 | -145,5059538 |
| 14 | -203,884 | 445,03778 | -0,4581 | -145,8127398 |
| 15 | 162,889 | 491,81404 | 0,3312 | -66,87996138 |
| 16 | 812,881 | 545,93205 | 1,4890 | 48,89783445 |

It is obvious that R/D = 1 for an ideal concentric surface (concentric to the object surface). In this case, the concentricity parameter CON = 0. In terms of values for the concentricity parameter CON an optical surface may be considered "essentially concentric" to the object surface where the concentricity parameter is less than about 20%. Within these limits, the mirror-side convex surface of lens L2 (surface 5) and the object-side concave surface of biconcave negative lens L4 (surface 8) may be considered as essentially concentric, whereas all other optical surfaces are non-concentric. Particularly, there is a large deviation from a concentric condition for the concave mirror CM indicated by a concentricity parameter CON = 48.9%. Further, the variation of concentricity between lens surfaces is irregular with a mix of larger and smaller deviations from concentricity and various changes between opposite sense of curvature between subsequent lens surfaces.

The projection objective provides a good correction of image-field curvature indicated by a Petzval sum near zero.

The projection objective is configured to allow an exposure of substrates utilizing light from a "design wavelength band". The term "design wavelength band" denotes a range of wavelengths including those wavelengths for which the optical performance of the projection objective is sufficiently good to allow diffraction limited imaging with relatively low aberration level. Where the configuration of the projection objective is such that the design wavelength band includes mercury g-, h- and i-lines, the projection objective may be used in conjunction with high power mercury-arc lamps as a light source of the projection exposure apparatus. Therefore, the optical performance is optimized for at least one of the mercury lines at about 365nm (i-line), about 405nm (h-line) and about 436nm (g-line), whereas the optical performance may deteriorate significantly outside the design wavelength band. Typically, a projection objective exclusively optimized for a design wavelength band including mercury g-, h- and i-lines cannot be operated for exposure at significantly smaller wavelength, such as in the deep ultraviolet (DUV) region with wavelength smaller than about 260nm and/or in the visible wavelength range, e.g. at wavelength larger than about 500nm.

The projection objective may be designed such that there is only one common focus at or close to one of the mercury lines, e.g. around the i-line at about 365nm. In the embodiments described above, the projection objective has two, three or more common foci at respective two or more wavelengths in the design wavelength band. Where the projection objective is corrected for two or more wavelength, those wavelengths may be used for exposure, whereby a larger fraction of the output power of the mercury light source can be utilized for the exposure. In that case, a higher throughput may be obtained.

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications as fall within the spirit and scope of the invention, as defined by the appended claims, and equivalents thereof.

**Claims**

1. A catadioptric projection objective comprising:

   a plurality of optical elements arranged along an optical axis to image a pattern arranged in an object surface into an image surface of the projection objective at unit magnification, the optical elements including:

   a concave mirror positioned at a pupil surface;
   a lens arrangement including a plurality of lenses;
   a first reflecting surface arranged between the object surface and the lens arrangement to deflect radiation from the object surface towards the concave mirror;
   a second reflecting surface arranged between the lens arrangement and
   the image surface to deflect radiation from the concave mirror towards the image surface;

   wherein at least one lens of the lens arrangement is positioned in a pupil space adjacent to the pupil surface at a position where the condition $|SAR_P| < 0.2$ is fulfilled for the paraxial sub-aperture ratio SARp defined as:

   $$SAR_P = (sign \ MRH_P) \cdot (CRH_P / (|MRH_P| + |CRH_P|)),$$

   where $CRH_P$ is a paraxial chief ray height and $MRH_P$ is a paraxial marginal ray height.

2. Projection objective according to claim 1, wherein the lens arrangement includes a pupil-side lens having a pupil-side lens surface immediately adjacent to the concave mirror at a position where the condition $|SAR_P| < 0.15$ holds.

3. Projection objective according to claim 1 or 2, wherein wherein at least two lenses of the lens arrangement are arranged within the pupil space.

4. Projection objective according to one of the preceding claims, wherein the lenses of the lens arrangement are optically distributed between field surfaces, formed by the object surface and image surface, and the pupil surface such that at least one lens of the lens arrangement is positioned optically near to a field surface where the condition $|SAR_P| > 0.5$ holds, at least one lens of the lens arrangement is positioned in an intermediate region where the condition $0.5 \geq |SAR_P| \geq 0.2$ holds and at least one lens is arranged within the pupil space.

5. Projection objective according to one of the preceding claims, wherein the concave mirror is a non-concentric mirror having a concavely curved mirror surface with a center of curvature substantially offset to the position of the object surface.

6. Projection objective according to one of the preceding claims, wherein the concave mirror is positioned at a distance $D_M$ (measured along the optical axis) from the object surface and has a radius $R_M$ of curvature, wherein the condition:

   $$CON = |1 - R_M/D_M| > 25\%$$

   is fulfilled for the concentricity parameter CON.

7. Projection objective according to one of the preceding claims, wherein the object surface and the image surface are aligned parallel to each other.

8. Projection objective according to one of the preceding claims, wherein a first distance D1 measured along the optical axis between the object surface and the first reflecting surface and a second distance D2 measured along the optical axis between the second reflecting surface and the image surface each are larger than the free optical radius $OR_{MAX}$ of a largest lens arranged in a region adjacent to the object surface and image surface where the condition $|SAR_P| > 0.4$ holds.

9. Projection objective according to claim 8, wherein the condition $D1 > 1.1 \cdot OR_{MAX}$ and $D2 > 1.1 \cdot OR_{MAX}$ holds.

**10.** Projection objective according to claim 8 or 9, wherein the first distance D1 and the second distance D2 each is larger than a free optical radius of each of the lenses of the lens arrangement and of the concave mirror.

**11.** Projection objective according to one of the preceding claims,
wherein
the object surface is aligned parallel to the image surface;
a first distance measured along the optical axis between the object surface and the first reflecting surface, and a second distance measured along the optical axis between the second reflecting surface and the image surface each are larger than a free optical radius of each of the lenses of the lens arrangement and of the concave mirror;
whereby each of the lenses of the lens arrangement and the concave mirror fit within a space defined by planes defined by the object surface and image surface, respectively.

**12.** Projection objective according to one of the preceding claims, wherein a working distance WD, measured along the optical axis, between a lens surface directly adjacent to the object surface (or image surface) and the object surface (or image surface, respectively) is larger than a free optical radius OR1 of a first lens immediately adjacent to the object surface and image surface such that the condition WD > OR1 holds.

**13.** Projection objective according to claim 12, wherein at least one of the conditions WD > 1.1 · OR1 and WD > 1.2 · OR1 and WD > 1.3 · OR1 and WD > 1.4 · OR1 holds.

**14.** Projection objective according to one of the preceding claims, wherein at least one of the conditions WD > 100 mm and WD > 110 mm and WD > 120 mm and WD > 130 mm and WD > 140 mm holds for a working distance WD measured along the optical axis between a lens surface directly adjacent to the object surface (or image surface) and the object surface (or image surface, respectively).

**15.** Projection objective according to one of the preceding claims, wherein no optical element having substantial refractive power is arranged between at least one of the object surface and the first reflection surface and the second reflecting surface and the image surface.

**16.** Projection objective according to one of the preceding claims, wherein a free optical radius $OR_M$ of the concave mirror is smaller than a maximum free optical radius $OR_{MAX}$ of a largest lens of the lens arrangement.

**17.** Projection objective according to one of the preceding claims, wherein a difference in free optical radius between the concave mirror and a largest lens of the lens arrangement is at least 5%.

**18.** Projection objective according to one of the preceding claims, wherein the projection objective has at least one focus at a wavelength in a design wavelength band that includes mercury g-, h- and i-lines.

**19.** Projection objective according to claim 18, wherein the projection objective has two or three or more common foci at respective two or three or more wavelengths in the design wavelength band.

**20.** A projection exposure system comprising:

a light source emitting primary radiation from a wavelength band including mercury g-, h- and i-lines;
an illumination system configured to receive light from the light source and to form an illumination field in an exit surface of the illumination system, and
a catadioptric projection objective according to one of the preceding claims.

Fig. 1

**European Patent
Office**

**EUROPEAN SEARCH REPORT**

Application Number

EP 07 00 2983

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FR 2 885 234 A (SAGEM SA SA [FR]) 3 November 2006 (2006-11-03) * page 5, line 17 - page 9; figures 5-7 * ----- | 1-20 | INV. G02B17/08 |
| X | WO 2006/117378 A (SAGEM DEFENSE SECURITE [FR]; TANNE JEAN-FRANCOIS [FR]; MICHELIN JEAN-L) 9 November 2006 (2006-11-09) * page 7, line 15 - page 140; figures 5,6 * ----- | 1-3,5-20 | |
| X | US 5 052 763 A (SINGH RAMA N [US] ET AL) 1 October 1991 (1991-10-01) * column 6, line 43 - column 8, line 57; figures 4,6,7,9 * ----- | 1,2,7, 15,18-20 | |
| X | US 4 171 871 A (DILL FREDERICK H [US] ET AL) 23 October 1979 (1979-10-23) * figures 1,2,3a,3b,9 * ----- | 1-3,7, 15,18-20 | |
| X | DE 101 40 806 A1 (ZEISS CARL JENA GMBH [DE]) 6 March 2003 (2003-03-06) * paragraphs [0047] - [0073]; figures 1-8 * ----- | 1,2,7, 15,18-20 | TECHNICAL FIELDS SEARCHED (IPC) G02B |

The present search report has been drawn up for all claims

| Place of search | Date of completion of the search | Examiner |
|---|---|---|
| Munich | 25 June 2007 | Casse, Martin |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 07 00 2983

This annex lists the patent family members relating to the patent documents cited in the above-mentioned European search report.
The members are as contained in the European Patent Office EDP file on
The European Patent Office is in no way liable for these particulars which are merely given for the purpose of information.

25-06-2007

| Patent document cited in search report | | Publication date | Patent family member(s) | | Publication date |
|---|---|---|---|---|---|
| FR 2885234 | A | 03-11-2006 | FR | 2885235 A1 | 03-11-2006 |
| WO 2006117378 | A | 09-11-2006 | NONE | | |
| US 5052763 | A | 01-10-1991 | CA | 2045944 A1 | 01-03-1992 |
| | | | DE | 69125328 D1 | 30-04-1997 |
| | | | DE | 69125328 T2 | 25-09-1997 |
| | | | EP | 0475020 A2 | 18-03-1992 |
| | | | JP | 4234722 A | 24-08-1992 |
| | | | JP | 7111512 B | 29-11-1995 |
| US 4171871 | A | 23-10-1979 | CA | 1095760 A1 | 17-02-1981 |
| | | | DE | 2828530 A1 | 11-01-1979 |
| | | | FR | 2396319 A1 | 26-01-1979 |
| | | | GB | 1559666 A | 23-01-1980 |
| | | | JP | 1336229 C | 11-09-1986 |
| | | | JP | 54013329 A | 31-01-1979 |
| | | | JP | 60055807 B | 06-12-1985 |
| DE 10140806 | A1 | 06-03-2003 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6813098 B2
- US 6879383 B2
- US 20060092395 A1
- US 6381077 B1
- US 6863403 B2

**Non-patent literature cited in the description**

- **MICHAEL J. KIDGER.** Fundamental Optical Design. SPIE PRESS